# EUROPÄISCHE PATENTSCHRIFT

(11) **EP 2 614 681 B1**
(45) Veröffentlichungstag und Bekanntmachung des Hinweises auf die Patenterteilung: **17.06.2015**
(21) Anmeldenummer: 11748311.5
(22) Anmeldetag: 25.07.2011
(51) Int. Cl.: H05B 33/08, H01L 41/04

(54) **BELEUCHTUNGSVORRICHTUNG**
ILLUMINATION DEVICE
APPAREIL D'ECLAIRAGE

(30) Priorität: 10.09.2010 DE 102010045054
(43) Veröffentlichungstag der Anmeldung: 17.07.2013
(73) Patentinhaber: OSRAM Opto Semiconductors GmbH, 93055 Regensburg (DE)
(72) Erfinder: HERRMANN, Siegfried, 94362 Neukirchen (DE); VON MALM, Norwin, 93152 Nittendorf - Thumhausen (DE); HÖPPEL, Lutz, 93087 Alteglofsheim (DE)
(74) Vertreter: Epping - Hermann - Fischer
(86) Internationale Anmeldenummer: PCT/EP2011/062741
(87) Internationale Veröffentlichungsnummer: WO 2012/031823

(56) Entgegenhaltungen:
- WO-A1-2010/034277
- WO-A1-2010/097407
- DE-A1-102008 051 044
- US-A1- 2009 261 740

## Beschreibung

Es wird eine Beleuchtungsvorrichtung angegeben.

Eine zu lösende Aufgabe besteht darin, eine Beleuchtungsvorrichtung anzugeben, die besonders kleine geometrische Abmessungen sowie ein besonders geringes Gewicht aufweist.

Gemäß zumindest der Ausführungsform der Beleuchtungsvorrichtung umfasst die Beleuchtungsvorrichtung einen Piezo-Transformator. Im Vergleich beispielsweise zu einem magnetisch arbeitenden Transformator zeichnet sich ein Piezo-Transformator durch seine hohe Effizienz und sein kleines Volumen aus. Der Piezo-Transformator enthält oder besteht aus wenigstens einem keramischen Material. Insbesondere kann der Piezo-Transformator als keramisches Material ein Blei-Zirkonat-Titanat (PZT) enthalten. Ferner ist es möglich, dass der Piezo-Transformator frei von Schwermetallen ist. Piezo-Transformatoren sind beispielsweise in den Druckschriften DK 176870 B1 und US 2007/0024254 A1 beschrieben, deren Offenbarungsgehalt hiermit ausdrücklich durch Rückbezug aufgenommen ist.

Der Piezo-Transformator weist eine Montagefläche auf. An der Montagefläche des Piezo-Transformators kann eine weitere Komponente der Beleuchtungsvorrichtung befestigt werden. An der Montagefläche des Piezo-Transformators sind zumindest zwei ausgangsseitige Anschlussstellen angeordnet. An den ausgangsseitigen Anschlussstellen stellt der Piezo-Transformator elektrischen Strom und Spannung zum Betreiben einer an die ausgangsseitigen Anschlussstellen anzuschließenden Komponente der Beleuchtungsvorrichtung zur Verfügung. Die Anschlussstellen können beispielsweise als Metallisierungen an der Montagefläche des Piezo-Transformators ausgebildet sein.

Gemäß zumindest einer Ausführungsform der Beleuchtungsvorrichtung umfasst die Beleuchtungsvorrichtung zumindest eine substratlose Lumineszenzdiode. Unter einer Lumineszenzdiode wird vorliegend eine Leuchtdiode oder eine Laserdiode verstanden, die im Betrieb elektromagnetische Strahlung beispielsweise im Wellenlängenbereich zwischen UV-Strahlung und Infrarot-Strahlung erzeugt. Beispielsweise ist die substratlose Lumineszenzdiode zur Emission von Licht im sichtbaren Spektralbereich eingerichtet.

"Substratlos" bedeutet, dass die Lumineszenzdiode kein Aufwachssubstrat aufweist. Das heißt, ein Aufwachssubstrat, auf das Halbleiterschichten, die einen Halbleiterkörper der Lumineszenzdiode bilden, beispielsweise epitaktisch abgeschieden sind, ist vom Halbleiterkörper der Lumineszenzdiode entfernt. Die substratlose Lumineszenzdiode ist damit frei von einem Aufwachssubstrat. Ferner ist die substratlose Lumineszenzdiode vorzugsweise frei von einem Trägerkörper. Das heißt, die substratlose Lumineszenzdiode besteht beispielsweise ausschließlich aus einem epitaktisch gewachsenen Halbleiterkörper, auf dem Metallisierungen zum Anschließen und zumindest eine Passivierungsschicht zum stellenweise elektrischen Isolieren angeordnet sein können.

Gemäß zumindest einer Ausführungsform der Beleuchtungsvorrichtung ist die zumindest eine substratlose Lumineszenzdiode zumindest mittelbar auf die Montagefläche des Piezo-Transformators aufgebracht und mechanisch an der Montagefläche befestigt. "Zumindest mittelbar" heißt dabei, dass sich zwischen der Lumineszenzdiode und der Montagefläche des Piezo-Transformators beispielsweise ein Zwischenträger befinden kann. Die zumindest eine substratlose Lumineszenzdiode kann dann über den Zwischenträger mechanisch an der Montagefläche befestigt sein. Die zumindest eine substratlose Lumineszenzdiode ist ferner elektrisch an zumindest zwei der ausgangsseitigen Anschlussstellen leitend angeschlossen.

Das heißt, die zumindest eine substratlose Lumineszenzdiode wird über die zumindest zwei ausgangsseitigen Anschlussstellen mit der für ihren Betrieb notwendigen Spannung und den für ihren Betrieb notwendigen elektrischen Strom versorgt. Die zumindest eine substratlose Lumineszenzdiode kann dabei mittelbar elektrisch leitend an zumindest zwei der ausgangsseitigen Anschlussstellen angeschlossen sein, das heißt es können sich beispielsweise Leiterbahnen zwischen der substratlosen Lumineszenzdiode und den ausgangsseitigen Anschlussstellen befinden. Darüber hinaus ist es möglich, dass die substratlose Lumineszenzdiode direkt an zumindest zwei der ausgangsseitigen Anschlussstellen elektrisch leitend angeschlossen ist, beispielsweise kann die substratlose Lumineszenzdiode dann an die ausgangsseitigen Anschlussstellen angelötet oder elektrisch leitend angeklebt sein.

Gemäß zumindest einer Ausführungsform der Beleuchtungsvorrichtung umfasst die Beleuchtungsvorrichtung einen Piezo-Transformator, der eine Montagefläche aufweist, an der zumindest zwei ausgangsseitige Anschlussstellen angeordnet sind und zumindest eine substratlose Lumineszenzdiode, die zur Erzeugung von elektromagnetischer Strahlung eingerichtet ist. Dabei ist die zumindest eine substratlose Lumineszenzdiode zumindest mittelbar auf die Montagefläche aufgebracht und mechanisch an der Montagefläche befestigt. Die zumindest eine substratlose Lumineszenzdiode ist elektrisch an zumindest zwei der ausgangsseitigen Anschlussstellen leitend angeschlossen.

Einer hier beschriebenen Beleuchtungsvorrichtung liegt dabei unter anderem die folgende Erkenntnis zugrunde: Durch die Verwendung eines Piezo-Transformators als Trägerelement für die zumindest eine substratlose Lumineszenzdiode ergibt sich eine Beleuchtungsvorrichtung mit besonders kleinen geometrischen Abmessungen. Beispielsweise führt die Verwendung eines Piezo-Transformators mit einer substratlosen Lumineszenzdiode zu einer Beleuchtungsvorrichtung, die eine besonders geringe Dicke aufweist. Eine solche Beleuchtungsvorrichtung eignet sich besonders gut zum Einsatz als Leuchtmittel beispielsweise in der Allgemeinbeleuchtung. Beispielsweise können auf diese Weise extrem dünne Leuchtkacheln (so genannte LED-Panels) gebildet werden, die sich beispielsweise auch als Boden-, Decken- oder Wandbelag im Sinne von Fliesen eignen.

Die Beleuchtungsvorrichtung kann genau eine substratlose Lumineszenzdiode, zumindest zwei substratlose Lumineszenzdioden, bevorzugt mehrere substratlose Lumineszenzdioden umfassen. Dabei weist die Beleuchtungsvorrichtung dann vorzugsweise einen einzigen Piezo-Transformator auf, der elektrischen Strom und Spannung für alle Lumineszenzdioden der Beleuchtungsvorrichtung zur Verfügung stellt.

Gemäß zumindest einer Ausführungsform der Beleuchtungsvorrichtung ist die zumindest eine substratlose Lumineszenzdiode unmittelbar auf die Montagefläche aufgebracht. Das heißt, zwischen dem Piezo-Transformator und der zumindest einen substratlosen Lumineszenzdiode ist keine weitere Komponente der Beleuchtungsvorrichtung, wie beispielsweise ein Zwischenträger angeordnet. Beispielsweise sind an der Montagefläche Metallschichten aufgebracht, die zur Verschaltung und Befestigung der substratlosen Lumineszenzdiode dienen.

Da sich substratlose Lumineszenzdioden insbesondere durch ihre sehr geringe Dicke auszeichnen und aufgrund des Fehlens eines Substrats oder Trägers eine relativ hohe mechanische Flexibilität aufweisen, wird das Schwingungsverhalten des Piezo-Transformators durch die an der Montagefläche unmittelbar aufgebrachten substratlosen Lumineszenzdioden kaum oder gar nicht negativ beeinflusst. Die zumindest eine substratlose Lumineszenzdiode kann beispielsweise elektrisch leitend an die ausgangsseitigen Anschlussstellen des Piezo-Transformators geklebt oder gelötet sein.

Gemäß zumindest einer Ausführungsform der Beleuchtungsvorrichtung ist zwischen der zumindest einen substratlosen Lumineszenzdiode und der Montagefläche des Piezo-Transformators ein Zwischenträger angeordnet, wobei der Zwischenträger Kontaktstellen umfasst und die zumindest zwei ausgangsseitigen Anschlussstellen und die zumindest eine substratlose Lumineszenzdiode elektrisch leitend an die Kontaktstellen angeschlossen sind. Mit anderen Worten vermittelt der Zwischenträger eine elektrisch leitende Verbindung zwischen der zumindest einen substratlosen Lumineszenzdiode und dem Piezo-Transformator. Bei dem Zwischenträger kann es sich beispielsweise um eine Platte nach Art einer Leiterplatte handeln, wobei der Zwischenträger neben den Kontaktstellen beispielsweise auch elektrische Leiterbahnen aufweisen kann, welche Kontaktstellen des Zwischenträgers elektrisch leitend miteinander verbinden. Der Zwischenträger kann dabei einen Grundkörper aufweisen, der beispielsweise mit Silizium oder einem keramischen Material gebildet ist. In und/oder auf dem Grundkörper sind dann die Kontaktstellen und gegebenenfalls die Leiterbahnen strukturiert. Die Verwendung eines Zwischenträgers bringt den Nachteil mit sich, dass das Schwingverhalten des Piezo-Transformators stärker verändert wird, als wenn kein Zwischenträger vorhanden ist. Dieser Nachteil kann durch die Verwendung eines besonders dünnen Zwischenträgers gering gehalten werden. Andererseits bietet der Zwischenträger weitere Designmöglichkeiten, da beispielsweise elektrisch passive Bauteile in den Zwischenträger integriert werden können, die zum Schutz oder zur Ansteuerung der zumindest einen substratlosen Lumineszenzdiode dienen.

Beispielsweise umfasst die Beleuchtungsvorrichtung mehrere substratlose Lumineszenzdioden. Alle substratlosen Lumineszenzdioden der Beleuchtungsvorrichtung sind dann auf der dem Piezo-Transformator abgewandten Oberseite des Zwischenträgers aufgebracht. Das heißt, die Beleuchtungsvorrichtung umfasst in diesem Fall einen einzigen Zwischenträger, einen einzigen Piezo-Transformator und zumindest eine, vorzugsweise eine Vielzahl substratloser Lumineszenzdioden.

Gemäß zumindest einer Ausführungsform der Beleuchtungsvorrichtung weist der Zwischenträger zumindest eine Durchkontaktierung auf, die sich von einer dem Piezo-Transformator zugewandten Unterseite des Zwischenträgers zu einer dem Piezo-Transformator abgewandten Oberseite des Zwischenträgers erstreckt, wobei die Durchkontaktierung eine ausgangsseitige Anschlussstelle des Piezo-Transformators elektrisch leitend mit zumindest einer der substratlosen Lumineszenzdioden verbindet. Das heißt, eine elektrisch leitende Verbindung zwischen der Unterseite des Zwischenträgers, welche dem Piezo-Transformator zugewandt ist und der Oberseite des Zwischenträgers, an welche sich die zumindest eine substratlose Lumineszenzdiode befindet, kann mittels einer Durchkontaktierung hergestellt sein, die sich durch einen Grundkörper des Zwischenträgers erstreckt. Auf diese Weise können großflächige Metallisierungen, die an der Außenfläche des Zwischenträgers ausgebildet sind und zur Verbindung von Unterseite und Oberseite dienen sollen, vermieden werden.

Gemäß zumindest einer Ausführungsform umfasst der Zwischenträger zumindest ein passives elektrisches Bauteil. Beispielsweise handelt es sich bei dem passiven elektrischen Bauteil um einen elektrischen Widerstand, ein ESD-Schutzbauteil wie beispielsweise eine ESD-Schutzdiode oder einen Varistor und/oder um eine Photodiode.

Das zumindest eine passive elektrische Bauteil kann dabei in einen Grundkörper des Zwischenträgers integriert sein, so dass das Bauteil an den Außenflächen des Zwischenträgers nicht übersteht, und die Dicke der Beleuchtungsvorrichtung durch das passive elektrische Bauteil also nicht erhöht wird. Beispielsweise kann der Zwischenträger ein ESD-Schutzbauteil umfassen, das einen Schutz für die zumindest eine substratlose Lumineszenzdiode gegen elektrostatische Entladung bildet. Dabei kann für jede substratlose Lumineszenzdiode ein eindeutig zugeordnetes ESD-Schutzbauteil im Zwischenträger vorhanden sein. Beispielsweise kann das ESD-Schutzbauteil als ESD-Schutzdiode ausgebildet sein, die durch entsprechende lokale Dotierung des Zwischenträgers gebildet ist. Der Zwischenträger kann dazu beispielsweise einen Grundkörper aufweisen, der aus einem Halbleitermaterial wie Silizium besteht.

Ferner ist es möglich, dass der Zwischenträger zumindest eine Photodiode umfasst, wobei die Photodiode dazu eingerichtet ist, von der zumindest einen substratlosen Lumineszenzdiode im Betrieb erzeugte elektromagnetische Strahlung zu detektieren. Eine solche Photodiode kann beispielsweise dazu Verwendung finden, die Funktionstüchtigkeit der substratlosen Lumineszenzdiode im Betrieb der Beleuchtungsvorrichtung zu kontrollieren. Alternativ oder zusätzlich ist es möglich, dass die Photodiode dazu eingerichtet ist, die Umgebungshelligkeit zu detektieren und mittels der Photodiode ein Einschalten der Beleuchtungsvorrichtung bei Unterschreiten einer bestimmten Umgebungshelligkeiten erfolgt.

Gemäß zumindest einer Ausführungsform der Beleuchtungsvorrichtung weist die zumindest eine substratlose Lumineszenzdiode eine Dicke von höchstens 10 µm, insbesondere von ≤ 6 µm auf. Eine solch dünne substratlose Lumineszenzdiode zeichnet sich durch ihr geringes Gewicht und ihre hohe mechanische Flexibilität aus. Unter Verzicht auf einen Zwischenträger verändert eine solche substratlose Lumineszenzdiode das Schwingverhalten des Piezo-Transformators kaum oder nicht.

Gemäß zumindest einer Ausführungsform der Beleuchtungsvorrichtung weist der Zwischenträger eine Dicke von höchstens 150 µm auf. Auch durch einen solch dünnen Zwischenträger ist es sichergestellt, dass das Schwingverhalten des Piezo-Transformators nur in geringem Maße negativ beeinflusst wird. Zum Beispiel weist der Zwischenträger eine Dicke von mindestens 50 µm auf. Dadurch ist eine hinreichende mechanische Stabilität des Zwischenträgers sichergestellt.

Gemäß zumindest einer Ausführungsform der Beleuchtungsvorrichtung schwingen die zumindest eine substratlose Lumineszenzdiode und/oder der Zwischenträger im Betrieb der Beleuchtungsvorrichtung mit derselben Frequenz wie ein Ausgangsteil des Piezo-Transformators mechanisch. Der Piezo-Transformator weist dabei beispielsweise ein Eingangsteil und ein Ausgangsteil auf. Das Eingangsteil und das Ausgangsteil des Piezo-Transformators sind mechanisch aneinander gekoppelt und galvanisch voneinander getrennt. Ein elektrisches Eingangssignal wird im Eingangsteil des Piezo-Transformators in mechanische Schwingungen umgewandelt. Aufgrund der mechanischen Kopplung des Eingangsteils und des Ausgangsteils sind beide Teile von der mechanischen Schwingung betroffen.

Die Umwandlung der elektrischen Energie in die mechanische Schwingung erfolgt dabei aufgrund des inversen piezoelektrischen Effekts. Im Ausgangsteil werden die mechanischen Schwingungen aufgrund des direkten piezoelektrischen Effekts zurück in ein elektrisches Signal verwandelt. Vorzugsweise können die substratlosen Lumineszenzdioden und/oder der Zwischenträger aufgrund ihrer geringen Dicke derart mit dem Ausgangsteil des Piezo-Transformators verbunden werden, dass sie mit derselben Frequenz wie das Ausgangsteil des Piezo-Transformators mechanisch schwingen. Das heißt, aufgrund der Flexibilität der zumindest einen substratlosen Lumineszenzdiode und/oder des Zwischenträgers ist eine mechanische Entkopplung zum Ausgangsteil des Piezo-Transformators nicht notwendig. Es kann daher insbesondere auf schwingungsdämpfende Maßnahmen zwischen den genannten Komponenten verzichtet werden.

Im Folgenden wird die hier beschriebene Beleuchtungsvorrichtung anhand von Ausführungsbeispielen und den dazugehörigen Figuren näher erläutert.

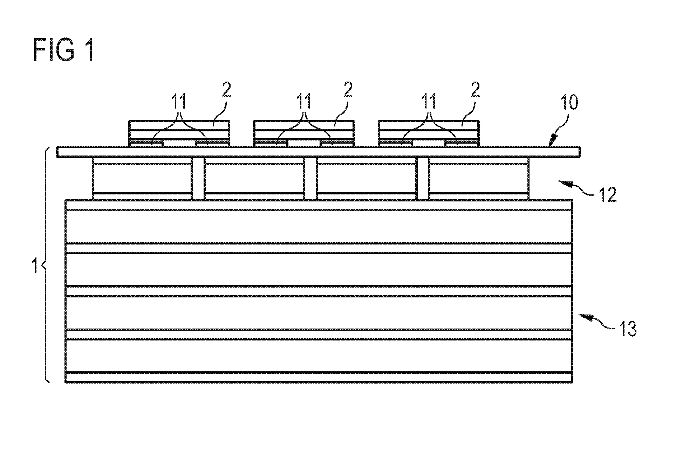

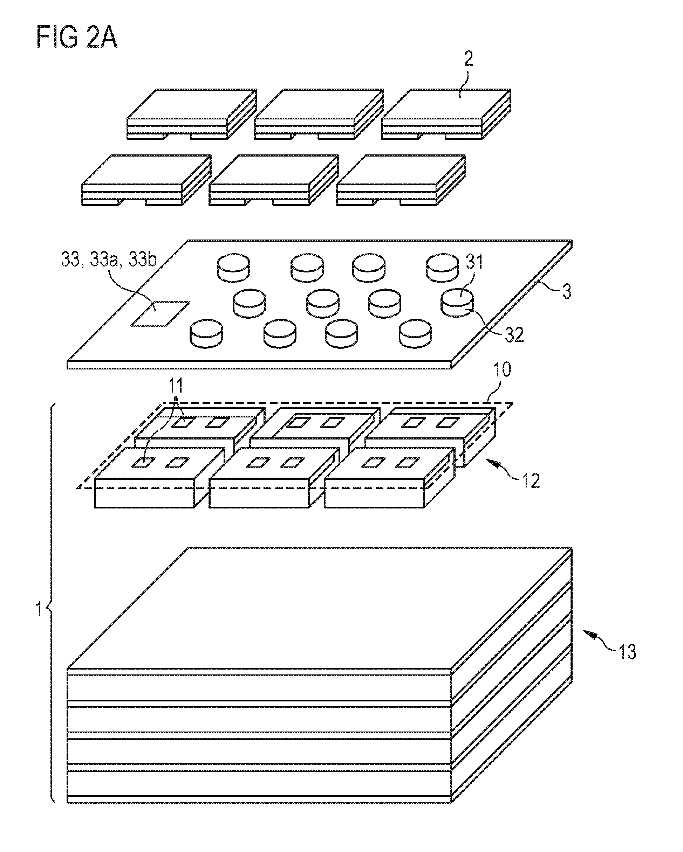

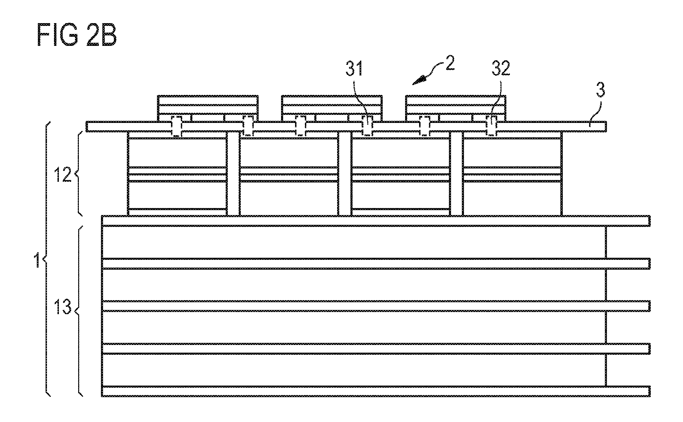

Die Figuren 1, 2A, 2B zeigen schematische Ansichten von hier beschriebenen Beleuchtungsvorrichtungen.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1 zeigt eine schematische Schnittdarstellung einer hier beschriebenen Beleuchtungsvorrichtung. Die Beleuchtungsvorrichtung umfasst einen Piezo-Transformator 1. Der Piezo-Transformator 1 umfasst ein Eingangsteil 13 und ein Ausgangsteil 12. Das Ausgangsteil 12 umfasst beispielsweise mehrere keramische Körper, die abwechselnd invertiert (das heißt die Ober- und die Unterseite wird abwechselnd vertauscht) auf dem Eingangsteil 13, das mit einem einzigen keramischen Körper gebildet ist, aufgebracht sind. An der dem Eingangsteil 13 abgewandten Seite weist das Ausgangsteil 12 eine Trennkeramik auf, welche an ihrer dem Eingangsteil 13 abgewandten Seite die Montagefläche 10 mit den ausgangsseitigen Anschlussstellen 11 umfasst.

An die ausgangsseitigen Anschlussstellen 11 sind substratlose Lumineszenzdioden 2, vorliegend substratlose Leuchtdioden, aufgebracht, sowie mechanisch und elektrisch leitend befestigt.

Vorliegend bildet also der Piezo-Transformator 1 den Träger für die substratlosen Leuchtdioden 2. Die Beleuchtungsvorrichtung kann auf diese Weise besonders dünn ausgebildet werden. Die Lumineszenzdioden 2 sind direkt, das heißt unmittelbar, an der Montagefläche 10 aufgebracht.

Die Figur 2A zeigt eine schematische Explosionsdarstellung eines weiteren Ausführungsbeispiels einer hier beschriebenen Beleuchtungsvorrichtung. Die Figur 2B zeigt die dazugehörige schematische Schnittansicht.

Im Unterschied zum Ausführungsbeispiel der Figur 1 weist die Beleuchtungsvorrichtung in diesem Ausführungsbeispiel einen Zwischenträger 3 auf. Der Zwischenträger 3 ist beispielsweise mit Silizium gebildet. Das heißt, der Zwischenträger 3 weist einen Grundkörper auf, der aus Silizium besteht. Der Zwischenträger 3 ist an der Montagefläche 10 des Piezo-Transformators 1 mechanisch befestigt. Durchkontaktierungen 32, die sich durch den Grundkörper des Zwischenträgers 3 erstrecken und beispielsweise mit einem Metall gebildet sind, sind elektrisch leitend mit den ausgangsseitigen Anschlussstellen 11 verbunden. Die Durchkontaktierungen 32 weisen an ihren Stirnflächen Kontaktstellen 31 auf. Die substratlosen Leuchtdioden 2 sind mit den Kontaktstellen 31 an der dem Piezo-Transformator 1 abgewandten Oberseite des Zwischenträgers 3 elektrisch leitend verbunden. Die ausgangsseitigen Anschlussstellen 11 des Piezo-Transformators sind mit nicht dargestellten Kontaktstellen 31 an der dem Piezo-Transformator zugewandten Unterseite des Zwischenträgers 3 elektrisch leitend verbunden.

Der Zwischenträger 3 umfasst ferner zumindest ein elektrisch passives Bauteil wie beispielsweise ein ESD-Schutzbauteil 33a und/oder eine Photodiode 33b. Das elektrisch passive Bauteil 3 kann dabei in den Grundkörper des Zwischenträgers 3 integriert sein.

Das heißt, das Bauteil überragt den Grundkörper des Zwischenträgers 3 nicht, so dass der Zwischenträger 3 als Platte homogener Dicke ausgebildet ist. Beispielsweise beträgt die Dicke des Zwischenträgers 3 höchstens 150 µm. Die Dicke der substratlosen Lumineszenzdioden 2 beträgt beispielsweise höchstens 6 µm. Aufgrund der mechanischen Flexibilität von Zwischenträger 3 und substratlosen Leuchtdioden 2 ist es nicht notwendig, diese Komponenten mechanisch vom Piezo-Transformator 1 zu entkoppeln. Sie schwingen daher mechanisch mit dem Ausgangsteil 12 des Piezo-Transformators 1 mit.

In den Figuren ist jeweils ein Piezo-Transformator 1 dargestellt, der einen quaderförmigen Aufbau aufweist. In Abänderung dieser Formgebung kann der Piezo-Transformator 1 auch beliebig andere Formen aufweisen. Beispielsweise kann der Piezo-Transformator 1 zylinderförmig, kegelstumpfförmig, ringförmig oder als Polygon ausgebildet sein.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Priorität der deutschen Patentanmeldung 10 2010 045 054.5, deren Offenbarungsgehalt hiermit durch Rückbezug aufgenommen wird.

## Patentansprüche

1. Beleuchtungsvorrichtung mit
- einem Piezo-Transformator (1), der eine Montagefläche (10) aufweist, an der zumindest zwei ausgangseitige Anschlussstellen (11) angeordnet sind, und
- zumindest einer substratlosen Lumineszenzdiode (2), die zur Erzeugung von elektromagnetischer Strahlung eingerichtet ist, wobei
- die zumindest eine substratlose Lumineszenzdiode (2) zumindest mittelbar auf die Montagefläche (10) aufgebracht und mechanisch an der Montagefläche (10) befestigt ist, und
- die zumindest eine substratlose Lumineszenzdiode (2) elektrisch an zumindest zwei der ausgangseitigen Anschlussstellen (11) elektrisch leitend angeschlossen ist.

2. Beleuchtungsvorrichtung nach dem vorherigen Anspruch, bei der die substratlose Lumineszenzdiode (2) ausschließlich aus einem epitaktisch gewachsenen Halbleiterkörper besteht, auf dem Metallisierungen zum elektrischen Anschließen und zumindest eine Passivierungsschicht zum stellenweise elektrischen Isolieren angeordnet sind.

3. Beleuchtungsvorrichtung nach einem der vorherigen Ansprüche,
bei der die zumindest eine substratlose Lumineszenzdiode (2) unmittelbar auf die Montagefläche (10) aufgebracht ist.

4. Beleuchtungsvorrichtung nach einem der vorherigen Ansprüche,
bei der zwischen der zumindest einen substratlosen Lumineszenzdiode (2) und der Montagefläche (10) ein Zwischenträger (3) angeordnet ist, wobei
- der Zwischenträger (3) Kontaktstellen (31) umfasst, und
- die zumindest zwei ausgangseitigen Anschlussstelle (11) und die zumindest eine substratlose Lumineszenzdiode (2) elektrisch leitend an die Kontaktstellen (31) angeschlossen sind.

5. Beleuchtungsvorrichtung nach einem der vorherigen Ansprüche,
bei der der Zwischenträger (3) zumindest eine Druckkontaktierung (32) aufweist, die sich von einer dem Piezo-Transformator (1) zugewandten Unterseite des Zwischenträgers (3) zu einer dem Piezo-Transformator (1) abgewandten Oberseite des Zwischenträgers (3) erstreckt, wobei die Durchkontaktierung (32) eine ausgangseitige Anschlussstelle (11) des Piezo-Transformators (1) elektrisch leitend mit zumindest einer der substratlose Lumineszenzdioden (2) verbindet.

6. Beleuchtungsvorrichtung nach einem der vorherigen Ansprüche,
bei der der Zwischenträger (3) zumindest ein passives elektrisches Bauteil (33) umfasst.

7. Beleuchtungsvorrichtung nach einem der vorherigen Ansprüche,
bei der der Zwischenträger (3) zumindest ein ESD-Schutzbauteil (33a) umfasst, das einen Schutz für die zumindest eine substratlose Lumineszenzdiode (2) gegen elektrostatische Entladungen bildet.

8. Beleuchtungsvorrichtung nach einem der vorherigen Ansprüche,
bei der der Zwischenträger (3) zumindest eine Photodiode (33b) umfasst, wobei die Photodiode (33b) dazu eingerichtet ist, von der zumindest einen substratlosen Lumineszenzdiode (2) im Betrieb erzeugte elektromagnetische Strahlung zu detektieren.

9. Beleuchtungsvorrichtung nach einem der vorherigen Ansprüche,
bei der die zumindest eine substratlose Lumineszenzdiode (2) eine Dicke von höchstens 10 µm aufweist.

10. Beleuchtungsvorrichtung nach einem der vorherigen Ansprüche,
bei der der Zwischenträger (3) eine Dicke von höchstens 150 µm aufweist.

11. Beleuchtungsvorrichtung nach einem der vorherigen Ansprüche,
bei der die zumindest eine substratlose Lumineszenzdiode (2) und/oder der Zwischenträger (3) im Betrieb der Beleuchtungsvorrichtung mit derselben Frequenz wie ein Ausgangsteil (12) des Piezo-Transformators (1) mechanisch schwingen.

## Claims

1. Lighting apparatus comprising
- a piezo-transformer (1), having a mounting face (10), at which at least two output-side connection locations (11) are arranged, and
- at least one substrateless luminescence diode (2) designed for generating electromagnetic radiation,
wherein
- the at least one substrateless luminescence diode (2) is at least indirectly applied to the mounting face (10) and mechanically fixed to the mounting face (10), and
- the at least one substrateless luminescence diode (2) is electrically conductively connected electrically to at least two of the output-side connection locations (11).

2. Lighting apparatus according to the preceding claim,
wherein the substrateless luminescence diode (2) exclusively consists of an epitaxially grown semiconductor body, on which are arranged metallizations for electrical connection and at least one passivation layer for electrical insulation in places.

3. Lighting apparatus according to either of the preceding claims,
wherein the at least one substrateless luminescence diode (2) is directly applied to the mounting face (10).

4. Lighting apparatus according to any of the preceding claims,
wherein an intermediate carrier (3) is arranged between the at least one substrateless luminescence diode (2) and the mounting face (10), wherein
- the intermediate carrier (3) comprises contact locations (31), and
- the at least two output-side connection locations (11) and the at least one substrateless luminescence diode (2) are electrically conductively connected to the contact locations (31).

5. Lighting apparatus according to any of the preceding claims,
wherein the intermediate carrier (3) has at least one plated-through hole (32) extending from an underside of the intermediate carrier (3) facing the piezo-transformer (1) to a top side of the intermediate carrier (3) facing away from the piezo-transformer (1), wherein the plated-through hole (32) electrically conductively connects an output-side connection location (11) of the piezo-transformer (1) to at least one of the substrateless luminescence diodes (2).

6. Lighting apparatus according to any of the preceding claims,
wherein the intermediate carrier (3) comprises at least one passive electrical component (33).

7. Lighting apparatus according to any of the preceding claims,
wherein the intermediate carrier (3) comprises at least one ESD protective component (33a) that forms protection for the at least one substrateless luminescence diode (2) against electrostatic discharges.

8. Lighting apparatus according to any of the preceding claims,
wherein the intermediate carrier (3) comprises at least one photodiode (33b) wherein the photodiode (33b) is designed to detect electromagnetic radiation generated by the at least one substrateless luminescence diode (2) during operation.

9. Lighting apparatus according to any of the preceding claims,
wherein the at least one substrateless luminescence diode (2) has a thickness of at most 10 µm.

10. Lighting apparatus according to any of the preceding claims,
wherein the intermediate carrier (3) has a thickness of at most 150 µm.

11. Lighting apparatus according to any of the preceding claims,
wherein the at least one substrateless luminescence diode (2) and/or the intermediate carrier (3) mechanically oscillate(s) with the same frequency as an output part (12) of the piezo-transformer (1) during the operation of the lighting apparatus.

## Revendications

1. Dispositif d'éclairage présentant
un transformateur piézo-électrique (1) qui présente une surface de montage (10) sur laquelle au moins deux emplacements de raccordement de sortie (11) sont disposés et
au moins une diode luminescente (2) exempte de substrat conçue pour produire un rayonnement électromagnétique, au cours de laquelle
la ou les diodes luminescentes (2) exemptes de substrat étant appliquées au moins indirectement sur la surface de montage (10) et étant fixées mécaniquement à la surface de montage (10) et
la ou les diodes luminescentes (2) exemptes de substrat étant raccordées électriquement de manière électriquement conductrice à au moins deux des emplacements de raccordement de sortie (11).

2. Dispositif d'éclairage selon la revendication précédente, dans lequel la diode luminescente (2) exemptes de substrat est exclusivement constituée d'un corps semi-conducteur formé par croissance épitaxique, sur lequel des métallisations sont disposées pour assurer le raccordement électrique et au moins une couche de passivation est disposée en certains endroits pour l'isoler électriquement.

3. Dispositif d'éclairage selon l'une des revendications précédentes, dans lequel la ou les diodes luminescentes (2) exemptes de substrat sont appliquées directement sur la surface de montage (10).

4. Dispositif d'éclairage selon l'une des revendications précédentes,
dans lequel un support intermédiaire (3) est disposé entre la ou les diodes luminescentes (2) exemptes de substrat et la surface de montage (10),
- le support intermédiaire (3) comprenant des emplacements de contact (31) et
- les deux ou plusieurs emplacements de raccordement de sortie (11) et la ou les diodes luminescentes (2) exemptes de substrat sont raccordées de manière électriquement conductrice aux emplacements de contact (31).

5. Dispositif d'éclairage selon l'une des revendications précédentes, dans lequel le support intermédiaire (3) présente au moins un contact de poussée (32) qui s'étend depuis un côté inférieur, tourné vers le transformateur piézo-électrique (1), du support intermédiaire (3) jusqu'áun côté supérieur, non tourné vers le transformateur piézo-électrique (1), du support intermédiaire (3), au cours de laquelle le contact de poussée (32) reliant un emplacement de raccordement de sortie (11) du transformateur piézo-électrique (1) de manière électriquement conductrice à au moins l'une des diodes luminescentes (2) exemptes de substrat.

6. Dispositif d'éclairage selon l'une des revendications précédentes, dans lequel le support intermédiaire (3) comporte au moins un composant électrique passif (33).

7. Dispositif d'éclairage selon l'une des revendications précédentes, dans lequel le support intermédiaire (3) comporte au moins un composant de protection ESD (33a) qui forme une protection contre les décharges électrostatiques de la ou des diodes luminescentes (2) exemptes de substrat.

8. Dispositif d'éclairage selon l'une des revendications précédentes, dans lequel le support intermédiaire (3) comporte au moins une photodiode (33b), la photodiode (33b) étant conçue pour détecter le rayonnement électromagnétique produit par la ou les diodes luminescentes (2) exemptes de substrat en fonctionnement.

9. Dispositif d'éclairage selon l'une des revendications précédentes, dans lequel la ou les diodes luminescentes (2) exemptes de substrat présentent une épaisseur d'au plus 10 µm.

10. Dispositif d'éclairage selon l'une des revendications précédentes, dans lequel le support intermédiaire (3) présente une épaisseur d'au plus 150 µm.

11. Dispositif d'éclairage selon l'une des revendications précédentes, dans lequel en fonctionnement, la ou les diodes luminescentes (2) exemptes de substrat et/ou le support intermédiaire (3) vibrent mécaniquement à la même fréquence qu'une partie de sortie (12) du transformateur piézo-électrique (1)
